# FASCICULE DE BREVET EUROPEEN

(11) **EP 0 743 753 B1**
(45) Date de publication et mention de la délivrance du brevet: **28.02.2001**
(21) Numéro de dépôt: 96410051.5
(22) Date de dépôt: 15.05.1996
(51) Int. Cl.: H03K 17/725

(54) **Modules interrupteurs et d'alimentation utilisant des thyristors**
Schalt- und Versorgungsmodule mit Thyristoren
Switching and power supply units using thyristors

(30) Priorité: 19.05.1995 FR 9506265
(43) Date de publication de la demande: 20.11.1996
(73) Titulaire: STMicroelectronics S.A., 94250 Gentilly (FR)
(72) Inventeur: Pezzani, Robert, 37210 Vouvray (FR)
(74) Mandataire: de Beaumont, Michel

(56) Documents cités:
- EP-A- 0 101 543
- EP-A- 0 518 790
- WO-A-93/13469
- DE-A- 2 127 956
- FR-A- 2 222 801
- US-A- 5 023 521
- US-A- 5 162 966

## Description

La présente invention concerne le domaine des interrupteurs statiques et plus particulièrement des interrupteurs statiques dont le fonctionnement est commandé par un circuit intégré.

Un tel interrupteur est destiné à être placé sur un circuit en série avec une charge dont on veut réguler le courant. Un problème pratique qui se pose à l'installateur est qu'il faut prévoir une alimentation spécifique basse tension (5 à 15 volts) pour le circuit intégré. On cherche donc à former des modules qui comprennent l'interrupteur et une alimentation pour le circuit intégré, ce qui simplifie beaucoup le montage de ces interrupteurs et de leur circuit intégré de commande.

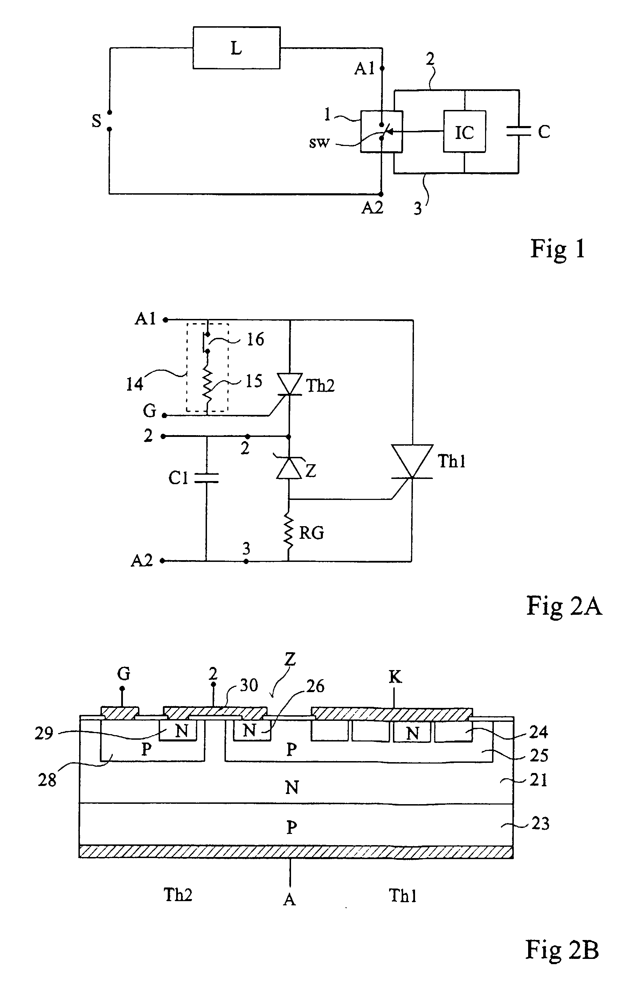

Ainsi, comme le représente la figure 1, on veut réaliser un circuit comprenant une source de tension S alimentant une charge L en série avec un module interrupteur 1. Ce module interrupteur est commandé par un circuit intégré IC. Le module interrupteur 1 comprend, d'une part, l'interrupteur proprement dit SW connecté entre des bornes A1 et A2, d'autre part, des bornes de sortie 2 et 3 d'alimentation du circuit intégré. Un problème particulier qui se pose avec de tels circuits est que quand l'interrupteur SW est fermé, la tension à ses bornes est faible ou nulle et que l'on ne peut donc plus disposer d'une tension suffisante entre les bornes 2 et 3. Pour remédier à cet état de chose, il a été prévu de disposer entre les bornes 2 et 3 un condensateur de stockage C.

De tels systèmes fonctionnent de façon satisfaisante mais nécessitent que le condensateur C soit de forte valeur pour le cas où la durée de fermeture de l'interrupteur serait longue. En effet, si la source S correspond à la tension alternative du secteur ou à cette tension alternative redressée, il faut prévoir le cas où la commande de l'interrupteur amène celui-ci à être fermé pendant plusieurs périodes de la tension du secteur.

Pour résoudre ce problème, on a prévu un interrupteur associé à un circuit de fourniture de basse tension conçu pour que, quand un ordre de fermeture est envoyé à l'interrupteur, cet ordre est inhibé tant que la tension aux bornes de l'interrupteur n'a pas atteint la tension de seuil d'alimentation souhaitée. Ainsi, un condensateur de stockage peut être rechargé au début de chaque alternance de tension appliquée et peut donc être de petite dimension.

Un circuit de ce type est décrit dans FR-A-2222801. Toutefois la réalisation d'un tel circuit implique l'utilisation et le câblage de nombreux composants.

Le document WO-A-93/13469 enseigne qu'un circuit comprenant des commutateurs détecteurs de proximité peut être intégré.

Un objet de la présente invention est de prévoir un module ayant les fonctions d'interrupteur et de source d'alimentation qui soit réalisable sous forme d'un composant semiconducteur monolithique.

Pour atteindre cet objet, la présente invention, prévoit un composant semiconducteur monolithique comprenant un premier thyristor ayant une gâchette, une anode et une cathode, la gâchette étant reliée à la cathode par une première résistance et à l'anode par la connexion en série d'une diode Zener basse tension et d'un deuxième thyristor. Les thyristors sont à structure verticale, et la diode Zener est de type latéral et est réalisée dans le caisson de gâchette du premier thyristor, la cathode de la diode Zener étant reliée à la cathode du deuxième thyristor par une métallisation constituant une borne de sortie.

La présente invention prévoit aussi un composant comprenant les caractéristiques de la revendication 5.

Selon un mode de réalisation de la présente invention, ce composant comprend en outre un contact entre ladite métallisation et le caisson de gâchette du premier thyristor, d'où il résulte qu'une résistance est formée en parallèle sur ladite diode Zener

Selon un mode de réalisation de la présente invention, une diode est formée dans un caisson à la surface supérieure du composant et est connectée entre le point de raccordement de la diode Zener et du deuxième thyristor et ladite borne de sortie.

Selon un mode de réalisation de la présente invention, le composant comprend en outre un quatrième thyristor vertical complémentaire du premier pour former avec celui-ci un triac.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :
la figure 1 représente un circuit comprenant un module interrupteur et d'alimentation selon l'art antérieur ;
la figure 2A représente un exemple de circuit de module interrupteur et d'alimentation ;
la figure 2B représente un mode de réalisation selon la présente invention sous forme de composant monolithique du circuit de la figure 2A ;
la figure 3 représente une courbe de tension en fonction du temps illustrant le fonctionnement du module de la figure 2 ;
la figure 4A représente un autre exemple de circuit de module interrupteur et d'alimentation ;
la figure 4B représente un mode de réalisation selon la présente invention sous forme de composant monolithique du circuit de la figure 4A ;
la figure 5A représente un autre exemple de circuit de module interrupteur et d'alimentation ;
la figure 5B représente un mode de réalisation selon la présente invention sous forme de composant monolithique du circuit de la figure 5A ;
la figure 6A représente un autre exemple de circuit de module interrupteur et d'alimentation ; et
la figure 6B représente un mode de réalisation selon la présente invention sous forme de composant monolithique du circuit de la figure 6A.

La figure 2A représente un exemple de circuit assurant la fonction du module 1 de la figure 1. Ce circuit est destiné à être connecté par des bornes A1 et A2 aux bornes d'une charge et d'une source d'alimentation, comme cela est représenté en figure 1. On considérera par souci de simplification que la borne A2 est une borne de masse.

L'interrupteur SW correspond à un thyristor principal Th1. La gâchette de ce thyristor est connectée à sa cathode par l'intermédiaire d'une résistance RG. Cette gâchette est également connectée à l'anode d'une diode Zener Z dont la cathode est reliée à la cathode d'un thyristor auxiliaire Th2 dont l'anode est reliée à l'anode du thyristor Th1. Le point commun du thyristor Th2 et de la diode Zener Z correspond à la borne 2 de la figure 1 et la borne A2 ou borne de masse correspond à la borne 3 de la figure 1. Entre ces bornes est disponible une tension d'alimentation pouvant par exemple servir à alimenter un circuit intégré. Un condensateur de stockage Cl est disposé entre les bornes 2 et 3. La borne de gâchette G du thyristor Th2 est destinée à recevoir un signal de commande en provenance du circuit intégré qui est alimenté par les bornes 2 et 3. Entre la gâchette et l'anode du thyristor Th2 est prévu un circuit d'amorçage 14, par exemple constitué d'une résistance 15 en série avec un interrupteur à bouton poussoir 16.

Quand on souhaite mettre en route une commande régulée du courant dans la charge L, on appuie sur le bouton poussoir 16. Ceci induit en conduction le thyristor Th2 et dans un premier temps celui-ci charge le condensateur C1 jusqu'à ce que la tension aux bornes de ce condensateur atteigne la tension de seuil de la diode Zener Z. A partir de ce moment, le condensateur C1 est suffisamment chargé pour alimenter le circuit intégré qui fournira des signaux de commande sur la gâchette G du thyristor. Le bouton poussoir est alors relâché et le système peut fonctionner en mode régulé par son circuit intégré de commande. Chaque fois qu'un signal de gâchette est appliqué au thyristor Th2, dans un premier temps, le condensateur est rechargé et, ensuite seulement, un courant circulera dans la gâchette du thyristor Th1 qui entrera en conduction.

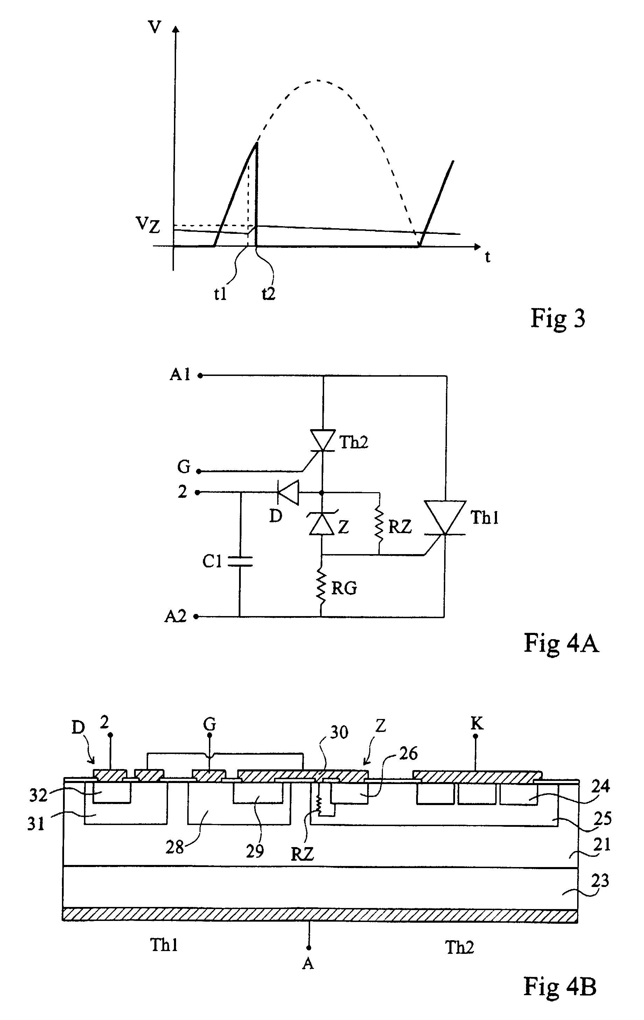

La figure 3 illustre le fonctionnement de ce circuit en régime établi. On suppose que la source S correspond à la tension du secteur redressé (tension de crête de l'ordre de 300 V). Si, à un instant t1, un signal de commande est appliqué à la borne G. le thyristor Th2 devient conducteur et, dans un premier temps, entre les instants t1 et t2, le condensateur C1 se recharge puis, quand la tension sur ce condensateur atteint la tension d'avalanche VZ de la diode Z, le thyristor Th1 entre en conduction. Ceci se reproduit à chaque alternance. Un phénomène similaire se produirait dans le cas d'une source alternative non redressée, auquel cas la commande ne se produirait que pour les alternances positives.

En fait, l'intervalle de temps t1-t2 sera extrêmement bref étant donné que, comme on l'a indiqué, la tension VZ est de l'ordre de 10 V alors que la tension de crête du signal de source est de l'ordre de 300 V dans une application courante.

La présente invention propose de réaliser le circuit de la figure 2A, du moins en ce qui concerne les composants Th2, Z. RG et Th1, sous forme d'un composant monolithique à partir d'un substrat semiconducteur 21 de type N.

La figure 2B illustre une telle réalisation. La face arrière du composant comprend une couche 23 de type P revêtue d'une métallisation de face arrière A qui correspond à l'anode des thyristors Th1 et Th2. Le thyristor Th1 est réalisé sous forme verticale et comprend à partir de la face supérieure une couche de cathode 24 munie de courts-circuits d'émetteur, formée dans un caisson 25 de type P lui-même formé dans le substrat 21. Dans une portion du caisson 25 est formée une région 26 de type N qui constitue avec ce caisson une jonction Zener correspondant à la diode Z. Un deuxième caisson 28 de type P comprenant une région 29 de type N permet de former le thyristor Th2 sous forme verticale, ce thyristor comprenant les régions 29, 28, 21 et 23. La cathode 29 du thyristor Th2 est reliée par une métallisation 30 à la cathode 26 de la diode Z.

La métallisation 30 correspond à la borne d'alimentation 2 de la figure 2A. Le caisson 28 est revêtu d'une métallisation de gâchette G. La résistance RG est constituée par la résistance de la région 25 sous la couche de cathode 24.

On notera que la figure 2B, comme toutes les figures ci-jointes qui représentent des vues en coupe de composants semiconducteurs, est fortement schématique, conformément à l'usage dans le domaine de la représentation des composants semiconducteurs.

L'homme de métier saura adapter la surface et la topographie des diverses couches et régions pour optimiser les caractéristiques du composant et notamment la capacité de passage de courant et la tension Zener.

Le circuit de la figure 2A et sa réalisation sous forme de composant semiconducteur monolithique sont susceptibles de nombreuses variantes dont certaines vont être décrites ci-après.

Une première variante de ce circuit est illustrée en figure 4A et sa réalisation sous forme de composant monolithique est illustrée en figure 4B.

La figure 4A représente les mêmes éléments que ceux de la figure 2A à l'exception du circuit de démarrage 14. En outre, le circuit de la figure 4A comprend une diode D et une résistance RZ. La diode D est disposée entre le point de raccordement du thyristor Th1 et de la diode Zener Z et la borne 2. La résistance RZ est en parallèle sur la diode Zener Z. Cette structure présente par rapport à la précédente l'avantage que la tension de commande sur la gâchette G par rapport à la masse sur la borne A2 peut être dans une plage de valeurs usuelles alors que, dans le cas du circuit de la figure 2A, elle devait être supérieure de VZ à ces valeurs usuelles. Ceci obligeait à munir le circuit intégré fournissant ce signal G d'un surélévateur de tension (booster) étant donné que la tension d'alimentation de ce circuit intégré correspondait précisément à la tension de la diode Zener.

Un mode de réalisation sous forme de composant monolithique du circuit de la figure 4A est illustré en figure 4B, on retrouve dans ce composant les mêmes éléments que ceux de la figure 2B avec en outre un caisson supplémentaire 31 de type P comprenant une région 32 de type N. Le caisson 31 est revêtu d'une métallisation qui est reliée à la métallisation 30 décrite en relation avec la figure 2 et ces métallisations ne sont plus reliées à une borne extérieure. La région 32 est revêtue d'une métallisation qui, elle, est reliée à la borne 2, destinée à être connectée au condensateur C1. La jonction entre les régions 31 et 32 constitue la diode D. En outre, la métallisation 30, au niveau de la région 26, n'est pas seulement en contact avec cette région 26 mais aussi avec une portion du caisson P 25 de façon à constituer la résistance RZ en parallèle sur la diode Z.

Une deuxième variante du circuit de la figure 2A est illustrée en figure 5A. La résistance RZ de la figure 4A est remplacée par un thyristor Th3 dont l'anode est reliée à la cathode de la diode Zener Z, dont la cathode est reliée à la résistance RG, et dont la gâchette est reliée à l'anode de la diode Z. En outre, une résistance RG3 est disposée entre gâchette et cathode du thyristor Th3. Ceci constitue un système d'amplification du courant de gâchette du thyristor Th1 et permet d'utiliser un thyristor Th1 qui sera peu sensible aux déclenchements parasites et dans lequel pourra passer un courant important.

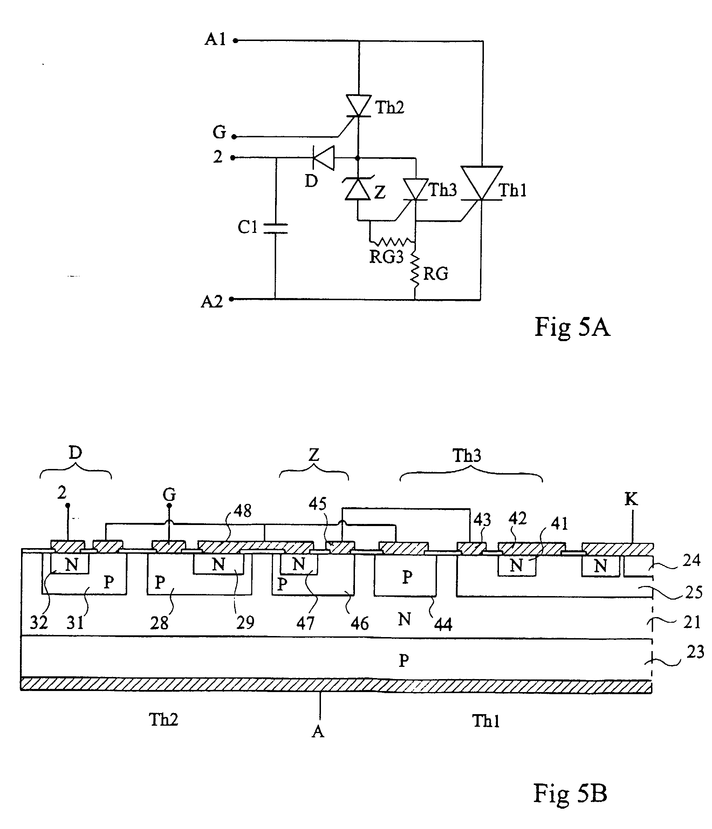

La figure 5B représente une structure mettant en oeuvre le circuit de la figure 5A. On retrouve dans la partie droite de la figure, le thyristor vertical Th1 constitué des régions 24, 25, 21 et 23. Le thyristor Th3 est réalisé sous forme latérale. Sa cathode est constituée d'une région 41 de type N formée dans le caisson 25 qui constitue la région de gâchette de ce thyristor Th3. Son anode est constituée d'une région 44 de type P formée au voisinage du caisson 25. Le thyristor Th3 comprend donc, de son anode vers sa cathode les régions 44, 21, 25, 41. La région de cathode 41 est revêtue d'une métallisation 42 également en contact avec une partie de la surface du caisson 25 pour former la liaison entre la cathode de Th3 et la gâchette de Th1. Une portion du caisson 25, qui constitue également la gâchette du thyristor Th3 est revêtue d'une métallisation 43 reliée à une métallisation 45 formée sur la partie supérieure d'un caisson 46 constituant l'anode de la diode Zener Z. Une région diffusée 47 constitue la cathode de cette diode Z et est reliée par une métallisation 48 à une région 29 de type N formée dans un caisson 28 qui correspondent respectivement à la cathode et à la région de gâchette du thyristor vertical Th1. Une métallisation de gâchette G est en contact avec une portion du caisson 28. On retrouve dans la partie gauche de la figure le caisson 31 et la région de type N 32 correspondant à la diode D de la figure 4. La cathode 32 de la diode est revêtue d'une métallisation destinée à être reliée à la borne 2 et l'anode de la diode est solidaire d'une métallisation reliée à la métallisation 48 décrite précédemment.

On peut combiner les modes de réalisation des figures 4A et 5A en prévoyant une résistance en parallèle sur la diode Z. Ceci amènera à modifier la structure de la figure 5B en prévoyant un contact entre la métallisation 48 et une portion du caisson 46, de même que, en figure 4B, il était prévu un contact entre la métallisation 30 et une portion du caisson 25.

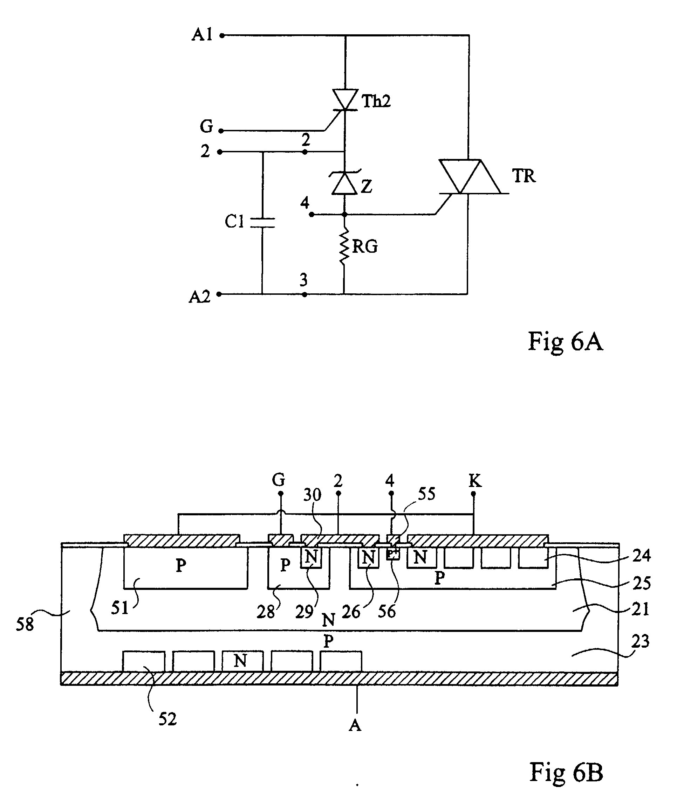

Une quatrième variante du circuit de la figure 2A (à l'exception du circuit de démarrage 14) apparaît en figure 6A dans laquelle le thyristor Th1 a été remplacé par un triac TR1. La gâchette du triac est en outre liée à une borne 4 destinée à être connectée au circuit intégré de commande pour permettre une mise en conduction du triac pendant les alternances négatives.

Une réalisation de ce circuit est illustrée en figure 6B. Dans la partie droite de la figure 6B, on retrouve exactement les mêmes couches, caissons et régions que dans la figure 2B. En outre, un caisson 51 de type P est formé dans la partie supérieure du substrat. Du côté de la face inférieure, sous ce caisson 51 et une partie au moins de la région de gâchette 28, est formée une région 52 de type N munie de trous de courts-circuits d'émetteur. Les régions 51, 21, 23 et 52 forment donc le deuxième thyristor du triac. Une métallisation revêtant le caisson 51 est reliée à la métallisation reliant la région 26 et forme une électrode principale du triac, désignée comme précédemment par la référence K. Une métallisation 55 est en contact d'une région 56, de préférence surdopée de type P, du caisson 25 et est destinée à constituer la borne de gâchette 4.

Bien entendu, cette structure est susceptible des diverses améliorations et variantes décrites en relation avec les figures 4 et 5.

En outre, on notera qu'à la figure 6B, on a représenté le triac entouré d'un caisson 58 de type P. Ceci est un exemple pratique de structure qui pourrait également être appliqué aux composants illustrés très schématiquement aux figures 2B, 4B et 5B.

## Revendications

1. Composant semiconducteur monolithique comprenant un premier thyristor (Th1) ayant une gâchette, une anode et une cathode, la gâchette étant reliée à la cathode par une première résistance (RG) et à l'anode par la connexion en série d'une diode Zener basse tension (Z) et d'un deuxième thyristor (Th2),
dans lequel les thyristors (Th1, Th2) sont à structure verticale, et la diode Zener (Z) est de type latéral, la cathode de la diode Zener étant reliée à la cathode du deuxième thyristor par une métallisation (30) constituant une borne de sortie (2).

2. Composant selon la revendication 1, dans lequel la diode Zener (Z) est réalisée dans le caisson de gâchette (25) du premier thyristor.

3. Composant selon la revendication 1, comprenant en outre un contact entre ladite métallisation (30) et le caisson de gâchette du premier thyristor, d'où il résulte qu'une résistance (RZ) est formée en parallèle sur ladite diode Zener

4. Composant selon la revendication 1, dans lequel une diode (D) est formée dans un caisson à la surface supérieure du composant et est connectée entre le point de raccordement de la diode Zener (Z) et du deuxième thyristor (Th2) et ladite borne de sortie (2).

5. Composant semiconducteur monolithique comprenant un premier thyristor (Th1) ayant une gâchette, une anode et une cathode, la gâchette étant reliée à la cathode par une première résistance (RG) et à l'anode par la connexion en série d'un deuxième thyristor (Th2) et d'un troisième thyristor (Th3), avec une diode Zener basse tension (Z) dont la cathode est reliée à l'anode du troisième thyristor et l'anode de la diode Zener est reliée à la gâchette du troisième thyristor, dans lequel les thyristors (Th1, Th2) sont à structure verticale, dans lequel la diode Zener (Z) est de type latéral, la cathode de la diode Zener étant reliée à la cathode du deuxième thyristor par une métallisation (30) constituant une borne de sortie (2), et dans lequel le troisième thyristor (Th3) est de type latéral, sa cathode (41) étant formée dans le caisson de gâchette de cathode (25) du premier thyristor.

6. Composant selon la revendication 1, comprenant en outre un quatrième thyristor vertical (51, 21, 23, 52) complémentaire du premier pour former avec celui-ci un triac.

## Patentansprüche

1. Monolithisches Halbleiterbauteil, welches einen ersten Thyristor (Th1) mit einem Gate, einer Anode und einer Kathode aufweist, wobei das Gate mit der Kathode über einen ersten Widerstand (RG) und mit der Anode über die Reihenschaltung einer Zenerdiode (Z) niedriger Spannung und eines zweiten Thyristors (Th2) verbunden ist,
wobei die Thyristoren (Th1, Th2) in dem Bauteil einen Vertikalaufbau aufweisen, die Zenerdiode (Z) vom Lateraltyp ist, und die Kathode der Zenerdiode mit der Kathode des zweiten Thyristors über eine, einen Ausgangsanschluß (2) bildende Metallisierung (30) verbunden ist.

2. Bauteil nach Anspruch 1, in welchem die Zenerdiode (Z) in dem Gate-Graben bzw. -kasten (25) des ersten Thyristors ausgebildet ist.

3. Bauteil nach Anspruch 1, das des weiteren einen Kontakt zwischen der genannten Metallisierung (30) und dem Gate-Kasten bzw. -graben des ersten Thyristors aufweist, mit dem Ergebnis, daß ein Widerstand (RZ) parallel zu der genannnten Zenerdiode gebildet wird.

4. Bauteil nach Anspruch 1, in welchem eine Diode (D) in einem Kasten bzw. Graben an der Oberseite des Bauteils ausgebildet und zwischen dem Verbindungspunkt der Zenerdiode (Z) und des zweiten Thyristors (Th2) und dem genannten Ausgangsanschluß (2) angeschlossen ist.

5. Monolithisches Halbleiter-Bauteil, welches einen ersten Thyristor (Th1) mit einem Gate, einer Anode und einer Kathode aufweist, wobei das Gate mit der Kathode über einen ersten Widerstand (RG) und mit der Anode über eine Reihenschaltung eines zweiten Thyristors (Th2) und eines dritten Thyristors (Th3) verbunden ist, mit einer Zenerdiode (Z) niedriger Spannung, deren Kathode mit der Anode des dritten Thyristors und deren Anode mit dem Gate des dritten Thyristors verbunden sind, wobei die Thyristoren (Th1, Th2) in dem Bauteil eine vertikale Struktur bilden, die Zenerdiode (Z) in dem Bauteil vom lateralen Typ ist und die Kathode der Zenerdiode mit der Kathode des zweiten Thyristors durch eine einen Ausgangsanschluß (2) bildende Metallisierung (30) verbunden ist, und wobei der dritte Thyristor (Th3) in dem Bauteil vom Lateraltyp ist und dessen Kathode (41) in dem Kasten bzw. Graben (25) des Kathodengates des ersten Thyristors ausgebildet ist.

6. Bauteil nach Anspruch 1, welches des weiteren einen vierten, vertikalen Thyristor (51, 21, 23, 52) aufweist, der komplementär zu dem ersten Thyristor ist und mit diesem ein Triac bildet.

## Claims

1. A monolithic semiconductor component comprising a first thyristor (Th1) having a gate, an anode and a cathode, the gate being connected to the cathode through a first resistor (RG) and to the anode through the series connection of a low-voltage zener diode (Z) and a second thyristor (Th2),
wherein the thyristors (Th1, Th2) are of the vertical type and the zener diode (Z) is of the lateral type, the cathode of the zener diode being connected to the cathode of the second thyristor through a metallization (30) forming an output terminal (2).

2. The component of claim 1, wherein the zener diode (Z) is formed in the gate well (25) of the first thyristor.

3. The component of claim 1, further comprising a contact between said metallization (30) and a gate well of said first thyristor, whereby a resistor (RZ) is formed in parallel with said zener diode.

4. The component of claim 1, wherein a diode (D) is formed in a well at an upper surface of the component and is connected between the junction of the zener diode (z) and the second thyristor (Th2) and said output terminal (2).

5. A monolithic semiconductor component comprising a first thyristor (Th1) having a gate, an anode and a cathode, the gate being connected to the cathode through a first resistor (RG) and to the anode through the series connection of a second thyristor (Th2) and a third thyristor (Th3) with a low-voltage zener diode (Z) the cathode of the zener diode (Z) being connected to the anode of the third thyristor, the anode of the zener diode being connected to the gate of the third thyristor wherein the thyristors (Th1, Th2) are of the vertical type and the zener diode (Z) is of the lateral type, the cathode of the zener diode being connected to the cathode of the second thyristor through a metallization (30) forming an output terminal (2) and wherein the third thyristor (Th3) is of the lateral type having a cathode (41) formed in the cathode-gate well (25) of said first thyristor.

6. The component of claim 1, further comprising a fourth thyristor of the vertical type (51, 21, 23, 52) complementary to the first thyristor and forming therewith a triac.
